# EUROPÄISCHE PATENTSCHRIFT

(11) **EP 0 625 870 B1**
(45) Veröffentlichungstag und Bekanntmachung des Hinweises auf die Patenterteilung: **12.06.1996**
(21) Anmeldenummer: 94104816.7
(22) Anmeldetag: 26.03.1994
(51) Int. Cl.: H05K 7/20

(54) **Vorrichtung zur Wärmeabfuhr aus einem Innenraum eines Schaltschrankes einer Textilmaschine**
Device for heat dissipation from a textile machine switch cabinet
Dispositif pour la dissipation de chaleur d'une armoire de commutation d'une machine textile

(30) Priorität: 21.05.1993 DE 4316999
(43) Veröffentlichungstag der Anmeldung: 23.11.1994
(73) Patentinhaber: Rieter Ingolstadt Spinnereimaschinenbau Aktiengesellschaft, 85046 Ingolstadt (DE)
(72) Erfinder: Jaeger, Wolfgang, D-73035 Göppingen (DE)

(56) Entgegenhaltungen:
- DE-A- 3 517 149
- US-A- 5 218 516
- IBM TECHNICAL DISCLOSURE BULLETIN., Bd.20, Nr.11A, April 1978, NEW YORK US Seiten 4346 - 4348 HARDIN 'INTEGRAL EDGE CONNECTOR'

## Beschreibung

Die Erfindung betrifft eine Vorrichtung zur Wärmeabfuhr aus einem Innenraum eines Schaltschrankes einer Textilmaschine. Unter solch einer Textilmaschine ist eine Maschine der Spinnerei oder Spulerei zu verstehen. Das kann beispielsweise eine Karde, Strecke, Flyer, Spinnmaschine oder Spulmaschine sein. Im Innenraum des Schaltschrankes, den jede dieser Textilmaschinen hat, sind elektrische, elektronische Geräte zum Betrieb der Textilmaschine installiert, die den Innenraum unzulässig erwärmen können, so daß durch die erhöhte Lufttemperatur die Arbeitsweise der elektrisch, elektronischen Geräte nachteilig beeinflußt werden kann. Kühlvorrichtungen sollen dies durch Abfuhr der Wärme aus dem Innenraum vermeiden.

Betriebswärme emittierende elektrische, elektronische Geräte sind beispielsweise Geräte der Leistungselektronik. Leistungselektronik befaßt sich mit der Steuerung und Umformung des elektrischen Leistungsflusses mittels elektronischer Bauelemente wie z.B. Thyritoren, Leistungstransistoren. Bei Betrieb dieser elektronischen Bauelemente entsteht Wärme, die sich aus der elektrischen Verlustleistung des Bauelementes ergibt und an die Umgebungsluft des Innenraums abgegeben wird. Zu diesem Zweck haben diese Bauelemente Kühlkörper erhalten. Durch den Kühlkörper wird die wirksame Kühlfläche für das Bauelement erhöht, denn diese Kühlkörper haben in der Regel das Profil von Kühlrippen. In Anlagen der Leistungselektronik sind in der Regel Leistungs- und Informationselektronik gemeinsam untergebracht. Die Leistungselektronik selbst ist mit ihrer elektronischen Steuerung zu einer Funktionseinheit zusammengefügt. Das entspricht einer modularen Bauweise. Beispielsweise ist ein Wechselrichter zur Steuerung eines Elektromotors modular aufgebaut. Dies wird als Wechselrichtermodul bezeichnet. Insbesondere solche Wechselrichtermodule sind die Ursache für die Erwärmung des Innenraumes. Erreicht die Lufttemperatur im Innenraum des Schaltschrankes unzulässige Werte, so wird die Arbeitsweise elektronischer Bauelemente, insbesondere die der Informationselektronik, nachteilig beeinflußt. Es kommt zu einer gestörten Arbeitsweise der Textilmaschine.

Um die Wärme aus dem Innenraum des Schaltschrankes einer Textilmaschine abzuführen, wird eine Kühlvorrichtung eingesetzt. Die Kühlvorrichtung ist eine Vorrichtung, wo der Austausch der Wärme vom Kühlkörper des elektrischen, elektronischen Gerätes zum Kühlmedium Luft erfolgt und die erwärmte Kühlluft abgeführt wird. Unter einer solchen Kühlvorrichtung ist insbesondere ein Kühlluftkanal mit Kühlkörpern zu verstehen.

Die DE-OS 35 17 149 beschreibt eine Kühlvorrichtung zum Abführen von Wärme aus einem Innenraum, in dem wärmeerzeugende elektrische oder elektronische Bauteile angeordnet sind. Der Innenraum wird gebildet durch das Gehäuse eines Schaltschrankes für Leistungselektronik. Dieses Gehäuse hat einen Kühlluftkanal, wobei der Kühlkörper (das ist ein metallischer Rippenkörper) auf die einzelne Seitenwandung des Kühlluftkanals montiert ist. Der Kühlluftkanal mit Kühlkörper hat die Aufgabe, die Wärme aus dem Innenraum abzuführen. Die Beschreibung geht davon aus, eine Kühlvorrichtung zu schaffen, die mit einer faserflugbelastenden Kühlluft arbeitet. Trotz faserflugbehafteter Kühlluft soll die Kühlwirkung der Kühlvorrichtung nicht störend beeinflußt werden.
Die Lösung geht davon aus, die Kühlluft des Kühlluftkanals schräg auf den Kühlkörper der Kühlvorrichtung auftreffen zu lassen. Diese Lösung erfordert deshalb einen abgewinkelten Kühlluftkanal, wobei im Bereich der Aufprallfläche der Kühlluftströmung die Kühlvorrichtung der Leistungselektronik angeordnet ist, so daß die Kühlluft mit Auftreffen auf den Kühlkörper eine Richtungsumlenkung erfährt und eine Kühlung ermöglicht. Durch die Richtungsumlenkung wird vermieden, daß sich Faserflug auf dem Kühlkörper absetzt und die Kühlwirkung reduziert.

Die Richtung der Luftströmung erfolgt von unten nach oben am Kühlkörper.
Wesentlich bei dieser Lösung ist, daß alle Kühlkörper der Leistungselektronik auf einer einzelnen Wandung des Kühlluftkanals installiert sein müssen, damit die Kühlluft auf alle Kühlkörper aufprallt und umgelenkt werden kann.
Die Anzahl der Kühlkörper nimmt Einfluß auf den Querschnitt und die Bauhöhe des Kühlluftkanals.
Nachteilig bei dieser Lösung ist, daß der Kühlluftkanal abgewinkelt sein muß. Das erfordert eine besondere, aufwendige Konstruktion des Kühlluftkanals.

Die Lösung EP 478 993 setzt einen hohen apparativen und konstruktiven Aufwand voraus. Charakteristisch dabei ist, daß die Kühlkörper für die Leistungselektronik auf einer Wandungsseite des Kühlluftkanals angeordnet sind und die Kühlluft nacheinander die Kühlkörper der Leistungselektronik von oben nach unten durchströmt.
Da die Kühlkörper der Leistungselektronik hintereinander längs im Kühlluftkanals angeordnet sind, ergibt sich der Nachteil, daß der Kühlluftkanal eine relativ große Bauhöhe beansprucht. Nachteilig ist weiterhin, daß die Leistungselektronik in der Gesamtheit mit der Informationselektronik im Kühlluftkanal angeordnet ist und somit in der Gesamtheit einer Verflugung ausgesetzt ist. Dies führt im allgemeinen zu kurzen Wartungsintervallen mit erhöhter Störanfälligkeit der Informationselektronik und erhöhtem Aufwand für die Reinigung.

Aufgabe der Erfindung ist es, den konstruktiven Aufwand zur Wärmeabfuhr aus Innenräumen eines Schaltschrankes einer Textilmaschine der Spinnerei oder Spulerei, die durch den Betrieb elektrischer, elektronischer Geräte erwärmt werden, weiter deutlich zu reduzieren.

Ein Merkmal der Erfindung ist, daß der Kühlluftkanal aus mehreren rohrförmigen Segmenten gebildet ist. Das rohrförmige Segment besteht in der bevorzugten Ausführung aus einem viereckigen Segment. Ein rohrförmiges Segment wird gebildet durch Anordung zweier Wechselrichtermodule im Schubfach eines Gestells. Mit der Anordnung im Schubfach eines Gestells werden die Kühlkörper zweier Wechselrichter bis auf einen kleinen Spalt in einer Ebene angeordnet, so daß sie zwei vollständige Wandungen eines rohrförmigen Segments bilden und die verbleibenden Wandungen des Segments durch das Gestell des Schaltschrankes gebildet werden. Die Wechselrichtermodule sind so im Schubfach eines Gestells angeordnet, daß sie das zu bildende Segment formschlüssig abdichten. Die vertikale Anordnung mehrerer solcher Segmente bildet den Kühlluftkanal, wobei die Kühlkörper so angeordnet sind, daß sie nicht nur im Kühlluftkanal installiert sind, sondern zugleich teilweise dessen Wandung bilden.

Die Anordnung kann gebildet werden durch eine gegeneinander geführte Anordnung zweier Wechselrichtermodule, wobei die Wechselrichtermodule gegeneinander, aber seitlich versetzt angeordnet sein können oder in Flucht gegeneinander angeordnet sein können. Ein weiteres Merkmal ist, daß Wechselrichtermodule auch miteinander in einer Einschubrichtung angeordnet sein können, wobei ein Wechselrichtermodul um 180° gedreht ist.

Die Erfindung erbringt den Vorteil, daß auf einfache Weise durch die Wechselrichtermodule selbst der Kühlluftkanal gebildet wird. Weiterhin gelingt es durch diese vorteilhafte Vorrichtung, die Bauhöhe des Kühlluftkanals um ungefähr die Hälfte gegenüber üblichen Bauhöhen zu reduzieren.

Da der Kühlluftkanal auf diese Weise modular aufgebaut werden kann, ist bei Erweiterung von Arbeitsstellen der Textilmaschine der Einsatz zusätzlicher Wechselrichtermodule möglich, ohne daß zusätzliche Konstruktionen notwendig werden. Dieser modulare Aufbau des Kühlluftkanals ermöglicht bezüglich der Erweiterung der Textilmaschine die Berücksichtigung individueller Kundenwünsche.

Eine besonders vorteilhafte Ausführung ermöglicht die Zugänglichkeit bei Wartung oder Inspektion von nur einer Seite des Schaltschrankes zu allen Wechselrichtermodulen.

Ein Ausführungsbeispiel der Erfindung wird anhand der Zeichnungen dargestellt und im folgenden näher beschrieben. Es zeigen
- Figur 1: Schema einer OE-Spinnmaschine,
- Figur 2: elektrischer Betriebsschrank einer OE-Spinnmaschine,
- Figur 3: prinzipieller Aufbau eines Gestells mit Schubfächern im Schaltschrank,
- Figur 4: Schema eines Wechselrichtermoduls,
- Figur 5: schematische Anordnung zweier Wechselrichtermodule in einem Schubfach des Schaltschrankes,
- Figur 6: schematische Darstellung eines Segmentes,
- Figur 7: Anordnung der Segmente zu einem Kühlluftkanal,
- Figur 8: Schema eines veränderten Wechselrichtermoduls,
- Figur 9: schematische Darstellung eines veränderten Segments,
- Figur 10: schematische Anordnung zweier Wechselrichtermodule in einer Einschubrichtung.

Für das Ausführungsbeispiel wurde aus der Vielzahl von Maschinen der Spinnerei die OE-Spinnmaschine (Rotorspinnmaschine) ausgewählt.

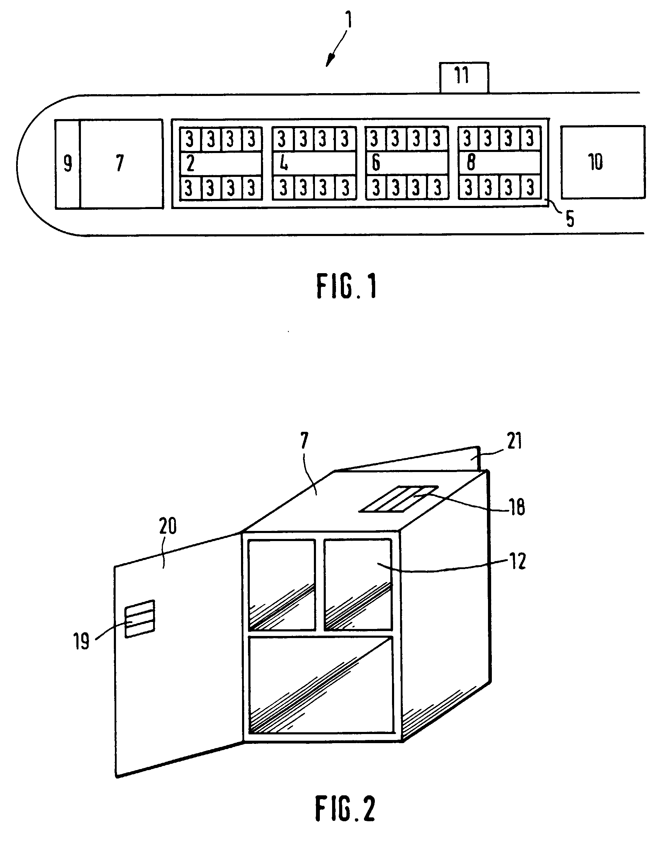

Wie Figur 1 verdeutlicht, besteht eine bekannte OE-Spinnmaschine 1 in ihrer Längsteilung aus einzelnen Sektionen 2,4,6,8. Die einzelne Sektion umfaßt als Montageeinheit einzelne Spinnstellen 3, in der Praxis ungefähr 20 Spinnstellen. In der Figur 1 sind symbolisch nur einige wenige dargestellt. Mehrere Sektionen 2,4,6,8 in Reihe montiert, bilden ein Sektionsgestell 5. Durch die hintereinander folgende Montage der Sektionen ist es möglich, für Arbeitsorgane der Spinnstellen 3 einen zentralen Antrieb zu installieren. An der Stirnseite des Sektionsgestells 5 ist ein elektrischer Betriebsschrank 7 angeordnet, welcher räumlich unterteilt ist und u.a. den zentralen Antrieb für Arbeitsorgane der Spinnstellen beinhaltet. Der elektrische Betriebsschrank 7, der in der Praxis auch als Antriebsgestell bezeichnet wird, ist in der Regel noch gekoppelt mit einem Hülsenlader 9, der die Versorgung der Spinnstellen 3 mit Leerhülsen gewährleistet. An der entgegengesetzten Stirnseite des Sektionsgestells befindet sich das Endgestell 10 mit der Spulenabführung. Das Endgestell 10 enthält im wesentlichen Elektronik zur Steuerung und Regelung der Maschine. Auf einem nicht dargestellten Schienensystem an der OE-Spinnmaschine 1 kann ein schienengeführter Wanderautomat 11 die Maschine umfahren, so daß er von der einen zur anderen Maschinenseite wechseln kann.

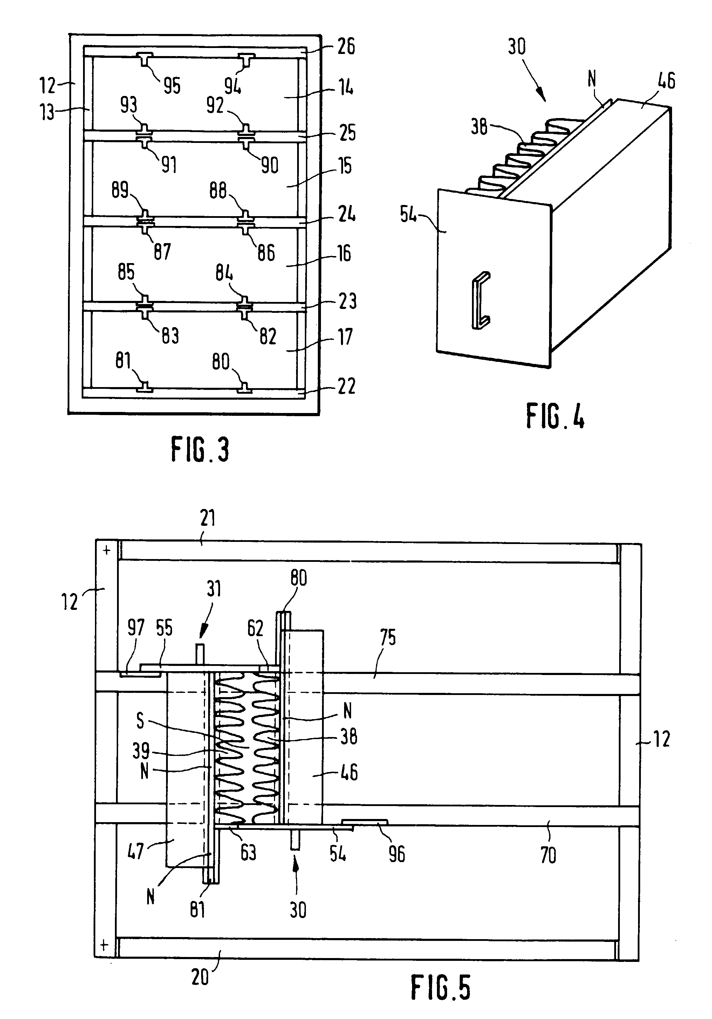

Im elektrischen Betriebsschrank 7 befindet sich u.a. das Gehäuse eines Schaltschrankes 12 (Figur 2). Dieser Schaltschrank 12 ist sowohl von der rechten Seite der Maschine als auch von der linken Seite her über eine Tür 20 und 21 zu öffnen und zu schließen. Nach Figur 3 hat dieser Schaltschrank 12 ein Gestell 13, daß Schubfächer 14,15,16,17 bildet. Der Zugang zu jedem einzelnen Schubfach 14,15,16,17 ist über die Tür 20 und 21 sowohl von der linken als auch von der rechten Maschinenseite her möglich.

Wie Figur 3 in der Ansicht zeigt, besteht das Gestell 13 aus den Horizontalträgern 22,23,24,25,26 sowie den in der Bildebene verdeckten, aber räumlich dahinter liegenden Horizontalträgern. Je zwei Horizontalträger einer Einschubebene bilden die Auflagefläche eines Schubfaches. Auf den Horizontalträgern sind Querschienen 80 bis 95 befestigt. Auf den Querschienen können die Wechselrichtermodule mit ihrer Nut N eingeschoben werden. An den Horizontalträgern eines Schubfaches sind weiterhin zwei Anschläge vertikal, aber zueinander diagonal versetzt angeordnet. Die Anschläge dienen zur Begrenzung des Einschubweges eines Wechselrichters. Die Anschläge sind aus Gründen der Überschaubarkeit in Figur 3 nicht dargestellt, sondern auszugweise in Figur 5 als Anschläge 96, 97 dargestellt. In jedem einzelnen Schubfach (14, 15, 16, 17) sind zwei eines Wechselrichtermoduls 30 eingeführt.

Figur 4 zeigt schematisch ein Wechselrichtermodul 30. Sie zeigt das Wechselrichtermodul 30 in der Lage, wie es in ein Schubfach von Gestell 13 eingeschoben werden kann. Schematisch ist die Leistungs- und Informationselektronik 46 in dem dargestellten Volumen untergebracht. Seitlich befindet sich der Kühlkörper 38, der mit der Leistungs- und Informationselektronik 46 mechanisch verbunden ist. Der Kühlkörper hat metallische Kühlrippen, deren Zwischenräume vertikal zur Bildebene angeordnet sind. Zwischen Kühlkörper 38 und Leistungs- und Informationselektronik 46 ist eine Nut N eingelassen, die auch auf der Unterseite des abgebildeten Wechselrichtermoduls vorhanden ist. Leistungs- und Informationselektronik 46 und Kühlkörper 38 sind an einer Frontplatte 54 installiert. Wie dieses Wechselrichtermodul 30 sind analog auch die anderen Wechselrichtermodule aufgebaut. Je zwei Wechselrichtermodule werden sich gegenüberliegend in ein Schubfach eingeschoben.

Figur 5 zeigt ausschnittsweise in der Draufsicht Schubfach 17 des Gestells 13. Die beiden Wechselrichtermodule 30, 31 sind ins Schubfach 17 eingeschoben.

Wie Figur 5 im weiteren zeigt, besteht die Besonderheit darin, daß die beiden Wechselrichtermodule 30, 31 in der Ebene des Schubfaches 17 um 180° gegeneinander gestellt und zugleich seitlich versetzt angeordnet sind. Somit ist einer der beiden Wechselrichtermodule, die in einem gemeinsamen Schubfach 17 liegen, stets bei Bedarf von der gegenüberliegenden Türseite her ein- oder ausschiebbar. Diese gegenseitige Positionierung bringt den Vorteil, daß die Kühlkörper 38, 39 beider Wechselrichtermodule 30, 31 sich in einer Einschubebene bis auf einen Spalt S gegenüberliegen. Jedes Wechselrichtermodul 30, 31 hat eine Frontplatte 54, 55. Jede Frontplatte hat einen Griff, um das Wechselrichtermodul in das Schubfach hinein oder heraus bewegen zu können.

Die Anordnung der beiden Wechselrichtermodule 30, 31 sind Bestandteile eines Segmentes Q1 für den Kühlluftkanal K. Die Kühlkörper 38,39 der zwei Wechselrichtermodule 30,31 einschließlich Spalt S bilden die Breite B des Kühlluftkanals K. Das Segment Q1 für den Kühlluftkanal K wird im einzelnen gebildet aus den Kühlkörpern 38, 39, den Wandungssegmenten 62, 63 sowie den Frontplatten 54, 55. Diese Bauteile bilden vier Seitenwandungen des Segments Q1 für den Kühlluftkanal K. Eine Orginalität der Lösung besteht darin, daß jeweils zwei gegenüberliegende Kühlkörper selbst zwei von vier Wandungen bilden. Die Abdichtung zwischen dem oberen bzw. unteren Schubfach wird durch die Querschienen 80 bis 95 erreicht. In Figur 5 ist eine Abdichtung durch die Querschienen 80, 81 dargestellt. Das Wechselrichtermoduls 30 mit seiner Nut N liegt auf der Querschiene 80 und das Wechselrichtermodul 31 mit seiner Nut N liegt auf der Querschiene 81.

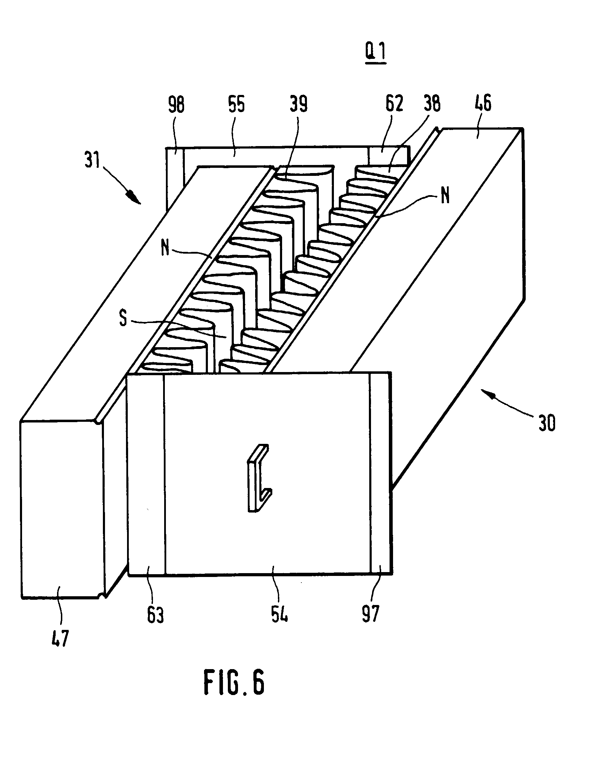

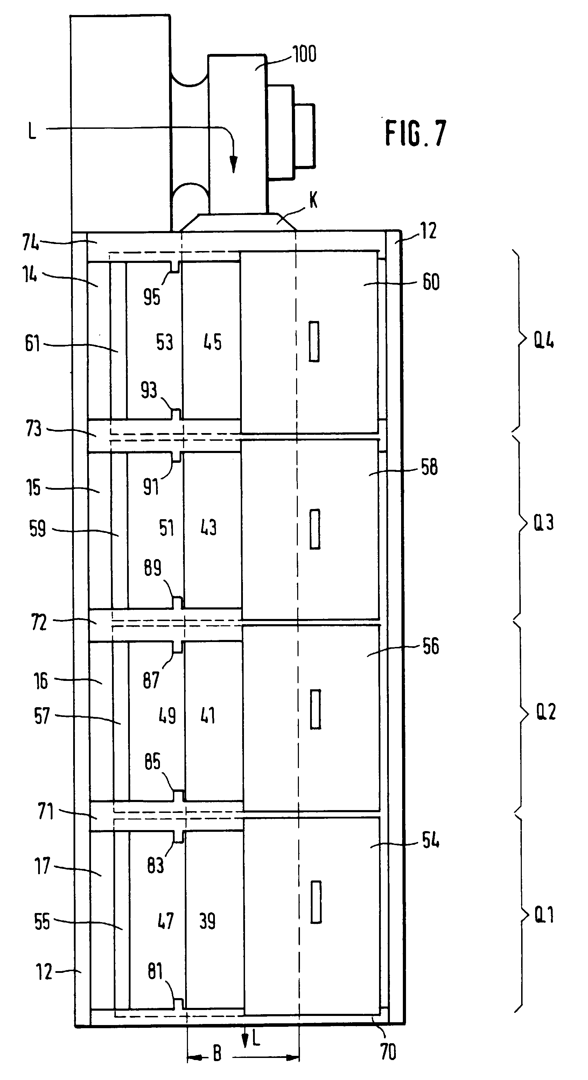

Figur 6 zeigt schematisch das Segment Q1. Für das Segment Q1 wird der Kühlluftkanal K gebildet durch Frontplatte 54 und 55, den Wandungssegmenten 62 und 63 und die Kühlkörper 38, 39. Die beiden Kühlkörper 38, 39 berühren einander nicht, sondern bilden einen kleinen Spalt S. Dieser Spalt S erbringt strömungstechnische Vorteile. Die Anordnung weiterer Wechselrichtermodule 32 bis 37 in den Schubfächern 14, 15 und 16 (siehe Figur 7) führt zu analogen Segmenten Q2, Q3, Q4, die in vertikaler Anordnung in ihrer Gesamtheit die Höhe des Kühlluftkanals K bilden.

Figur 7 zeigt eine solche Anordnung mehrerer Wechselrichtermodule.

Die Kühlkörper mit der Leistungs- und Informationselektronik der Wechselrichtermodule sind vollständig im Kühlluftkanal K installiert. Schematisch sind in der Darstellung von Figur 7 im wesentlichen nur die Wechselrichtermodule mit den Kühlkörpern 39, 41, 43, 45 sowie der dazugehörigen Leistungs- und Informationselektronik 47, 49, 51, 53 zu sehen. Von den anderen Wechselrichtermodulen sind nur die Frontplatten 54, 56, 58, 60 zu sehen. Mit Breite B ist die Breite des Kühlluftkanals K angedeutet. Ein Gebläse 100 ist oberhalb des Kühlluftkanals K am Lüftungseinlaß angeordnet. Bei Betrieb des Gebläses 100 wird die Luft L des Spinnsaales von oben mit großem Volumenstrom und hoher Luftgeschwindigkeit nach unten in den Kühlluftkanal K gedrückt, wobei die Luft L über den Lüftungsauslaß das Gehäuse des Schaltschrankes 12 verläßt. Diese Anordnung erbringt den Vorteil, daß kein Kühlluftkanal installiert sein muß, in dem die Kühlkörper der Wechselrichtermodule zusätzlich befestigt werden müssen. Die Anordnung kann wahlweise zu einer Grundausstattung von Wechselrichtermodulen erweitert werden, ohne daß man auf eine Konstruktionsvariante ausweichen müßte.

An Stelle nicht benützter Schubfächer wird zur Abdichtung ein sogenannter Blindeinschub, in Form einer Frontplatte mit einem Blech anstelle eines Wechselrichtermoduls, eingeschoben, so daß der Kühlluftkanal nach Innen und Außen dicht ist. Zur Reinigung und Wartung läßt sich jeder Einschub leicht herausziehen und z.B. mit Pressluft reinigen. Daß es zu keinen großen Ablagerungen auf dem Kühlkörper kommt, dafür sorgt die hohe Luftgeschwindigkeit.

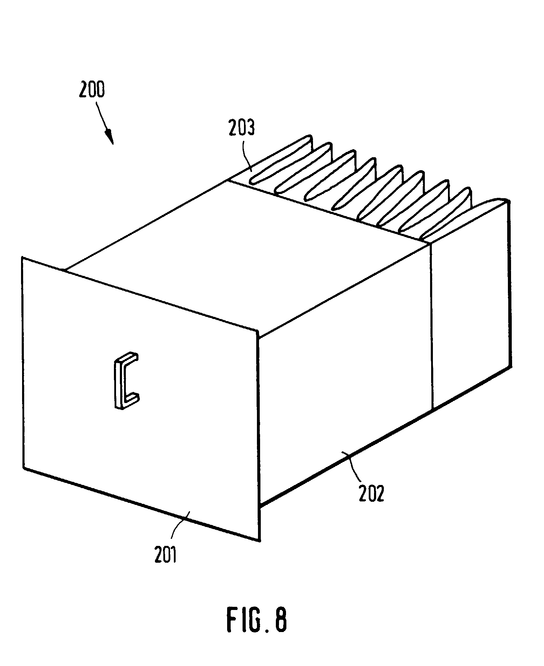

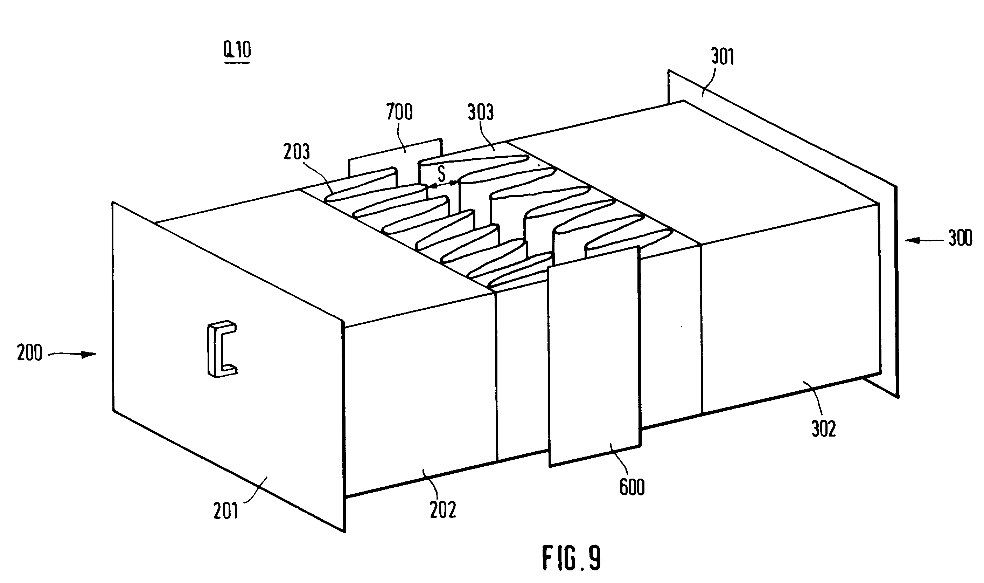

Nach Figur 8 sind in der Praxis auch ein Wechselrichtermodul 200 bekannt, welches eine abweichende Gestalt von den bisher gezeigten Wechselrichtermodulen hat. Auf Grundlage des Wechselrichtermoduls 200 nach Figur 8, wird nachfolgend eine veränderte Ausführung der Erfindung beschrieben. Kennzeichnend für den Wechselrichermodul 200 ist, daß ausgehend von der Frontplatte 201 hintereinander die Leistungs- und Informationselektronik 202 und der Kühlkörper 203 angeordnet sind. Bei Verwendung solcher Wechselrichtermodule, die den Aufbau wie Wechselrichtermodul 200 haben, wird vorgeschlagen, ein Segment Q10 entsprechend Figur 9 zu bilden. Von zwei einander gegenüberliegenden Seiten eines Schubfaches werden je zwei Wechselrichtermodule 200 und 300 eingeschoben. Der Kühlkörper 203 des Wechselrichtermodules 200 liegt dem Kühlkörper 303 des Wechselrichtermoduls 300 gegenüber. Es ist zu gewährleisten, daß ebenfalls zwischen den gegenüberliegenden Kühlkörpern 203 und 303 ein Spalt S bestehen bleibt. Die Seitenwandungen 600, 700 sind im Schubfach eines Gestells angeordnet und bilden die seitliche Abdeckung zu den Kühlkörpern. Gegenüber der vorangegangenen Ausführung ist das Gestell zu verändern. Die Schubfachfunktion des Gestells bleibt erhalten. Jedoch müssen die Seitenwandungen 600 und 700 so im Gestell angeordnet werden, daß die Kühlkörper formschlüssig und luftdichtend nach Einschub in die Endlage angeordnet sind. Auf Einzelheiten wurde in Figur 9 verzichtet. Das Segment Q10 wird gebildet aus den Kühlkörpern 203, 303 und den Wandsegmenten 600 und 700. Werden mehrere solcher Segmente Q10, die die gleiche Gestaltung haben, vertikal angeordnet, so wird ein Kühlluftkanal gebildet. Mindestens zwei, horizontal angeordnete Segmente Q10 bilden einen Kühlluftkanal.

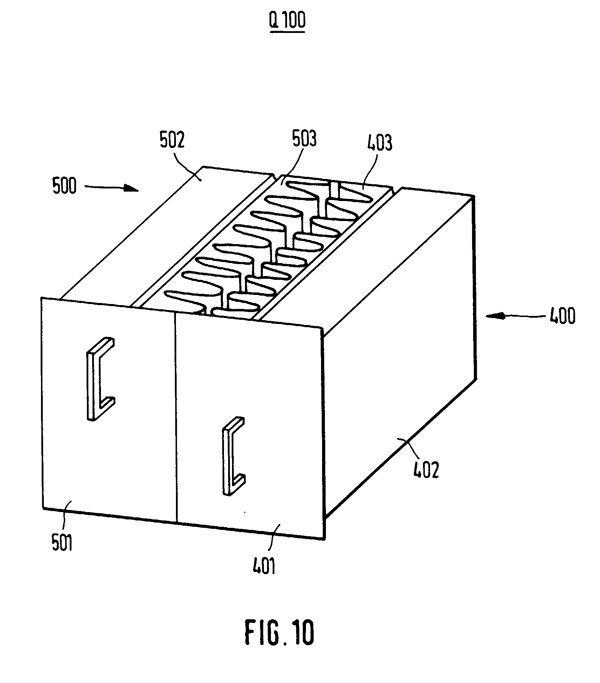

Figur 10 zeigt eine schematische Anordnung zweier Wechselrichtermodule 400, 500 in einer Einschubrichtung, d.h. beide Wechselrichtermodule werden von einer Seite des Schaltschrankes 12 eingeschoben. Die Wechselrichtermodule 400, 500 bilden das Segment Q100. Wenn beispielsweise das Wechselrichtermodul 500 in seiner Endlage angeordnet ist, besteht die Besonderheit darin, daß in gleicher Einschubrichtung aber um 180° gedreht, das Wechselrichtermodul 400 angeordnet ist.

Für das Segment Q100 wird der Kühlluftkanal gebildet durch die Frontplatten 401, 501, die Kühlkörper 403, 503 und ein in Figur 10 nicht dargestelltes Wandungssegment, das den Anschlag für beide Wechselrichtermodule darstellt und den Spalt zwischen den beiden Kühlkörpern 403, 503 abdichtet.

## Patentansprüche

1. Vorrichtung zur Wärmeabfuhr aus einem Innenraum eines Schaltschrankes einer Textilmaschine, der durch den Betrieb von Wechselrichtermodulen erwärmt wird, wobei diese in Schubfächern eines Schaltschrankes eingeschoben sind, so daß die Kühlkörper der Wechselrichtermodule in einem Kühlluftkanal angeordnet sind und die Kühlkörper einen Wandungsabschnitt des Kühlluftkanals bilden und die im Kühlluftkanal geförderte Kühlluft auf der Oberfläche der Kühlkörper entlangströmt, dadurch gekennzeichnet, daß je Schubfach eines Gestells (13) zwei Wechselrichtermodule (30, 31; 200, 300; 400, 500) mit ihrem Kühlkörper (38, 39; 203, 303; 403; 503) angeordnet sind, so daß alle Wandungsabschnitte eines rohrförmigen Segments (Q1, Q10, Q100) gebildet sind und die vertikale Anordnung mindestens zweier Segmente einen Kühlluftkanal (K) bilden.

2. Vorrichtung nach Anspruch 1, dadurch gekennzeichnet, daß die Wechselrichtermodule (30, 31) gegeneinander, aber seitlich versetzt angeordnet sind.

3. Vorrichtung nach einem oder beiden der Ansprüche 1 und 2, dadurch gekennzeichnet, daß alle Wandungsabschnitte eines Segments (Q1) gebildet werden aus den Kühlkörpern (38, 39), aus den Wandsegmenten (62, 63) und den Frontplatten (54, 55).

4. Vorrichtung nach Anspruch 2, dadurch gekennzeichnet, daß die Wechselrichtermodule (30, 31) zwischen den Kühlkörpern (38, 39) einen Spalt (S) bilden.

5. Vorrichtung nach Anspruch 1, dadurch gekennzeichnet, daß die Wechselrichtermodule (200, 300) in Flucht gegeneinander angeordnet sind, so daß deren Kühlkörper (203) und (303) mit den Wandsegmenten (600, 700) ein Segment (Q10) bilden.

6. Vorrichtung nach Anspruch 1, dadurch gekennzeichnet, daß die Wechselrichtermodule (400, 500) miteinander in einer Einschubrichtung angeordnet, aber ein Wechselrichtermodul um 180° gedreht ist, so daß deren Kühlkörper (403, 503) ein Segment (Q100) bilden.

## Claims

1. A device for dissipating heat from the interior of a switch cabinet of a textile machine, which is heated by the operation of inverted-rectifier modules, wherein the said inverted-rectifier modules are inserted into insertion compartments of a switch cabinet, so that the cooling bodies of the inverted-rectifier modules are arranged in a cooling-air duct and the cooling bodies form a wall portion of the cooling-air duct and the cooling air conveyed in the cooling-air duct flows along the surface of the cooling bodies, **characterized in that** two inverted-rectifier modules (30, 31; 200, 300; 400, 500) with their cooling bodies (38, 39; 203, 303; 403, 503) are arranged *per* insertion compartment of a switch cabinet (13), so that all the wall portions of a tubular segment (Q1, Q10, Q100) are formed and the vertical arrangement of at least two segments form[s] a cooling-air duct (K).

2. A device according to Claim 1, **characterized in that** the inverted-rectifier modules (30, 31) are arranged opposite each other but laterally offset.

3. A device according to one or both of Claims 1 and 2, **characterized in that** all the wall portions of a segment (Q1) are formed by the cooling bodies (38, 39), from the wall segments (62, 63) and from the front panels (54, 55).

4. A device according to Claim 2, **characterized in that** the inverted-rectifier modules (30, 31) form a gap (S) between the cooling bodies (38, 39).

5. A device according to Claim 1, **characterized in that** the inverted-rectifier modules (200, 300) are arranged in alignment with each other, so that the cooling bodies (203) and (303) thereof form a segment (Q10) with the wall segments (600, 700).

6. A device according to Claim 1, **characterized in that** the inverted-rectifier modules (400, 500) are arranged in one insertion direction with each other, but one inverted-rectifier module is turned through 180°, so that the cooling bodies (403, 503) thereof form a segment (Q100).

## Revendications

1. Dispositif pour la dissipation de chaleur de l'intérieur d'une armoire électrique d'une machine textile qui est chauffée par suite du fonctionnement de modules d'onduleurs, ceux-ci étant introduits dans les tiroirs d'une armoire électrique si bien que les dissipateurs de chaleur des modules d'onduleurs sont disposés dans un canal d'air refroidissant et que les dissipateurs de chaleur constituent une section de paroi du canal d'air refroidissant et que l'air refroidissant transporté dans le canal d'air refroidissant passe le long de la surface des dissipateurs de chaleur, caractérisé en ce que dans chaque tiroir d'un bâti (13) deux modules d'onduleurs (30, 31; 200, 300; 400, 500) avec leurs dissipateurs de chaleur (38, 39; 203, 303; 403; 503) sont disposés si bien que toutes les sections de paroi d'un segment tubulaire (Q1, Q10, Q100) sont constituées et que la disposition verticale d'au moins deux segments constitue un canal d'air refroidissant (K).

2. Dispositif selon la revendication 1, caractérisé en ce que les modules d'onduleurs (30, 31) sont disposés de façon opposée mais décalés latéralement l'un par rapport à l'autre.

3. Dispositif selon l'une des deux revendications 1 et 2, caractérisé en ce que toutes les sections de paroi d'un segment (Q1) sont constituées par les dissipateurs de chaleur (38, 39), par les parties de paroi (62, 63) et par les plaques frontales (54, 55).

4. Dispositif selon la revendication 2, caractérisé en ce que les modules d'onduleurs (30, 31) forment une fente (S) entre les dissipateurs de chaleur (38, 39).

5. Dispositif selon la revendication 1, caractérisé en ce que les modules d'onduleurs (200, 300) sont disposés de manière opposée tout en étant alignés si bien que leurs dissipateurs de chaleur (203) et (303) constituent un segment (Q10) conjointement avec les parties de paroi (600, 700).

6. Dispositif selon la revendication 1, caractérisé en ce que les modules d'onduleurs (400, 500) sont disposés ensemble dans un même sens d'introduction mais qu'un module d'onduleur est tourné de 180° de manière à ce que leurs dissipateurs de chaleur (403, 503) constituent un segment (Q100).
